**Europäisches Patentamt**

**European Patent Office**

**Office européen des brevets**

(11) Veröffentlichungsnummer: **0 186 857**
**B1**

(12) **EUROPÄISCHE PATENTSCHRIFT**

(45) Veröffentlichungstag der Patentschrift:
**11.10.89**

(51) Int. Cl.⁴: **H05K 7/18**

(21) Anmeldenummer: **85116140.6**

(22) Anmeldetag: **18.12.85**

(54) **Case-Gehäusesystem.**

(30) Priorität: **29.12.84 DE 3447791**

(43) Veröffentlichungstag der Anmeldung:
**09.07.86 Patentblatt 86/28**

(45) Bekanntmachung des Hinweises auf die Patenterteilung:
**11.10.89 Patentblatt 89/41**

(84) Benannte Vertragsstaaten:
**AT BE CH DE FR GB IT LI LU NL SE**

(56) Entgegenhaltungen:
**DE-A- 2 251 410**
**FR-A- 1 593 593**
**FR-A- 2 371 856**
**GB-A- 1 101 356**

(73) Patentinhaber: **Heidelberg, Ulrich,**
**Schimmelbuschstrasse 21, D-4006 Erkrath 2(DE)**

(72) Erfinder: **Heidelberg, Ulrich, Schimmelbuschstrasse 21,**
**D-4006 Erkrath 2(DE)**

(74) Vertreter: **Stratmann, Ernst, Dr.-Ing., Schadowplatz 9,**
**D-4000 Düsseldorf 1(DE)**

## Beschreibung

Die Erfindung betrifft ein Case-Gehäusesystem, bestehend aus einem aus Rack-Profilen aufgebauten Gehäuserahmensystem, in das elektronische Geräte oder dgl. einbringbar sind und das mit Abdeckwänden oder Abdeckhauben versehbar ist.

Derartige Case-Gehäusesysteme sind bereits bekannt, siehe beispielsweise einen Prospekt der Firma TEAC Corporation, Japan, mit der Bezeichnung "TASCAM" mit dem Druckdatum Januar 1984 und einen weiteren Prospekt dieser Firma mit der Bezeichnung "TASCAM Multitrack Serie" mit dem Druckdatum Januar 1983, sowie einen weiteren Prospekt der Firma MGM Cases, Wuppertal, der in der Zeitschrift "Sound & Music" Ende September 1984 veröffenlicht worden ist.

In Form von Patentschriften bekannt gewordener technologischer Hintergrund wird gebildet durch die FR-A 1 593 593, DE-A 2 251 410, GB-A 1 101 356 und FR-A 2 371 856.

Diese sogenannten "Cases", auch "Case in Case"-Konstruktion genannt, üblicherweise in 19-Zoll-Ausführung, dienen dazu, elektronische Geräte aufzunehmen, wie beispielsweise Mischpulte, Effektgeneratoren, Vorverstärker und Endstufen, Tonbandmaschinen, und ähnliches, wie Regelverstärker.

Diese Geräte besitzen üblicherweise eine langgestreckte Frontplatte mit seitlichen Bohrungen, mit denen das Gerät über diese Frontplatte an senkrechten Metallprofilen, sogenannten Rackschienen, mit Hilfe von Klemmschrauben befestigt werden können. Der so gebildete Gerätestapel ist in sich starr und wird unten und oben, an den Seiten sowie auf der Rückwand mit Sperrholzplatten verschlossen, während die Vorderfront von den Frontplatten gebildet wird. Dieser Stapel wiederum läßt sich dann in den fahrbaren Unterteil eines Schrankkoffers einsetzen, auf welchen Unterteil dann eine die gesamte Anordnung abdeckende Haube aufsetzbar und mittels beispielsweise eines Schmetterlingverschlusses verschließbar ist ("Case in Case").

Das System dient dazu, die für Musikergruppen notwendigen Gerätschaften sicher transportieren und schnell aufbauen zu können.

Nachteilig ist bei der bekannten Anordnung, daß Systemveränderungen nicht oder doch nur mit erheblichem Aufwand möglich sind. Dies führt dazu, daß praktisch die gesamte Ausrüstung auf den Fall zugeschnitten werden muß, der die meisten Geräte erfordert. In vielen Fällen sind aber viele dieser Geräte nicht notwendig und müßten daher an sich zu Konzerten und Auftritten nicht mitgenommen werden, was Platz und Gewicht einsparen und diese Geräte außerdem schonen würde. Angesichts der festen Zusammenstellung ist man jedoch gezwungen, stets die Gesamtausrüstung mit entsprechend großem Gewicht und entsprechend großem Raumbedarf mitzunehmen.

Ein weiterer Nachteil ist darin zu sehen, daß die bekannte Anordnung praktisch in Einzelfertigung herzustellen ist, was zu entsprechend hohen Fertigungskosten führt. Schließlich ist beim Stand der Technik mit Problemen zu rechnen, wenn Geräte mit hoher Wärmeentwicklung untergebracht werden müssen.

Aufgabe der Erfindung ist es, das bekannte Case-Gehäuse-system dahingehend zu verbessern, daß es in einfacher Weise eine Anpassung an die jeweils benötigten Geräte ermöglicht, so daß zum einen das zu transportierende Gewicht und der für den Transport benötigte Raum nur solche Geräte betrifft, die auch tatsächlich benötigt werden, zum anderen aber auch durch ein Modulsystem eine Massenfertigung und damit eine wesentlich billigere Herstellung der Case-Gehäuse ermöglicht wird. Dabei sollen auch Geräte mit hoher Wärmeentwicklung, bei denen z.B. Ventilatoren oder zusätzliche Lüftung notwendig sind, problemlos untergebracht werden können.

Gelöst wird diese Aufgabe dadurch, daß das Gehäuserahmensystem einen oder mehrere Rahmenmoduln umfaßt, jeweils bestehend aus einem oberen Basisrahmen sowie aus einem über Rack-Profilstücke mit dem oberen Basisrahmen verbundenen unteren Basisrahmen, wobei der obere Basisrahmen mit einer verriegelbaren Aufnahme für einen unteren Basisrahmen eines anderen Moduls versehen ist, und wobei der untere Basisrahmen zum verriegelbaren Einbringen in den oberen Basisrahmen eines weiteren Moduls, eines Case-Gehäuse-Kofferbodens oder einer Case-Gehäuse-Bodenauflage geeignet ist.

Durch diese Maßnahmen läßt sich ein Gehäusesystem aufbauen, das jeweils nur die Geräte umfaßt, die für einen bestimmten Anwendungsfall benötigt werden. Nicht benötigte Geräte lassen sich ohne großen Aufwand aus dem Gehäuserahmensystem durch Modulentnahme entfernen und zusätzlich benötigte Geräte in einfachster Weise durch Ergänzen eines entsprechenden Moduls hinzufügen. Auf diese Weise wird nur soviel Platz für den Transport in Anspruch genommen und nur ein solches Gewicht zu tragen sein, wie es die Anzahl der gerade benötigten Geräte erfordert. Andererseits setzt sich das Gehäusesystem aus nur sehr wenigen Elementen zusammen, im wesentlichen nämlich nur aus dem ersten Basisrahmen, dem zweiten Basisrahmen sowie den Rack-Profilstücken von jeweils an die Gerätehöhe angepaßter Länge. Die Anordnung ermöglicht auch ausreichende seitliche Freiflächen zur zusätzlichen Entlüftung, z.B. unter Ausnutzung des Schornsteineffektes.

Infolge diese flexiblen Aufbauweise ergeben sich nicht nur bei der Herstellung große Kostenvorteile, auch die Anwendung führt zu großen Kosten- und Zeiteinsparungen.

In den Unteransprüchen werden vorteilhafte Weiterbildungen der Erfindung gelehrt. So ergibt sich gemäß der Weiterbildung nach Anspruch 2 eine besonders preisgünstige Herstellung dadurch, daß der untere und der obere Basisrahmen rechteckig sind und aus L-Profilen bestehen, wobei auf zwei parallele (vorzugsweise sind es die längeren) Rahmenseiten U-Profile mit W-förmig ausgebildetem U-Steg-Profil aufgesetzt sind. Diese Profile sind im Handel erhältlich und daher sehr preisgünstig zu erwerben.

Von Vorteil ist es, wenn die W-Profilierung derart angeordnet ist, daß beim verriegelnden Zusammenbau eines oberen Basisrahmens mit einem unteren Basisrahmen die W-Profile der beiden Rahmen kammartig ineinandergreifen. Dies ergibt die durch diese W-Profilierung angestrebte genaue und spielfreie Passung der Rahmen (formschlüssige Verbindung in Vertikalrichtung).

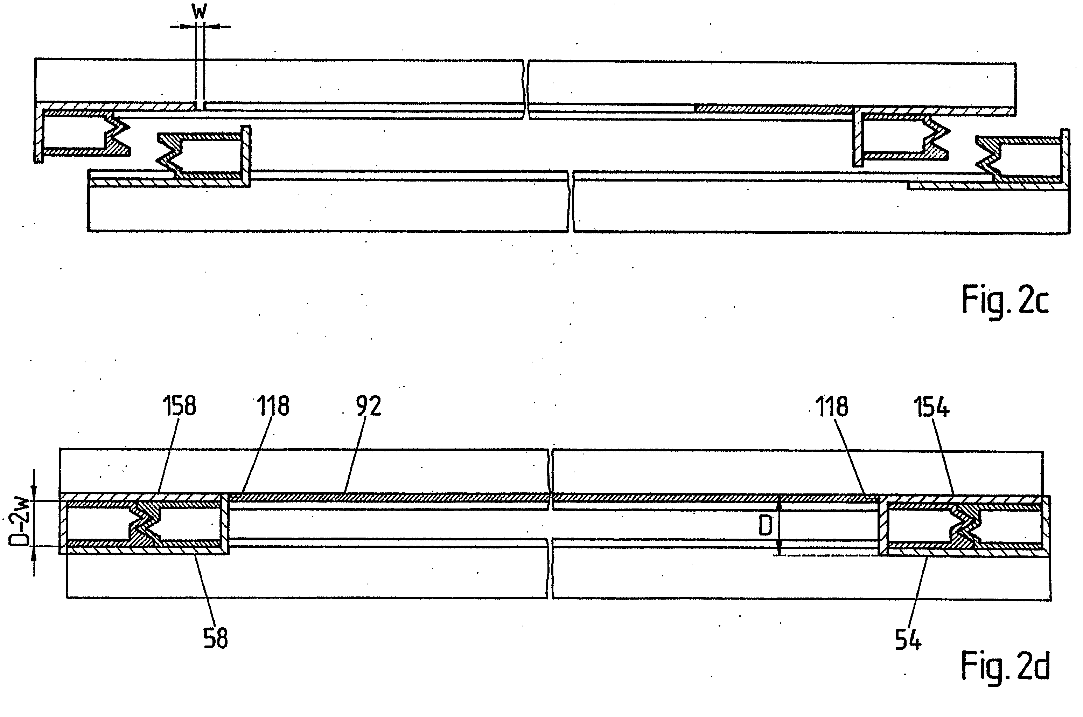

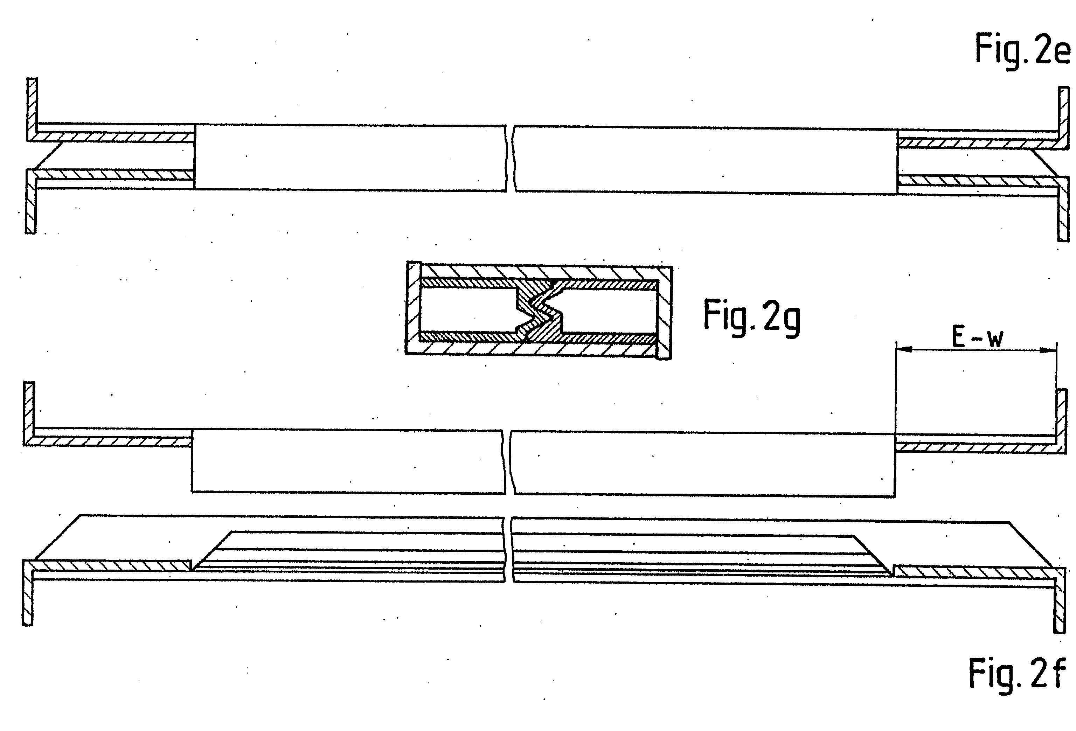

Üblicherweise wird das L-Profil unterschiedlich lange Schenkellängen aufweisen. In diesem Falle ist es günstig, wenn der Basisrahmen durch Aufeinanderlegen und Fixieren (beispielsweise mit Hilfe von Nietverbindungen, durch Kleben oder auch durch Schweißen) der längere Schenkel an den Rahmenecken derart aufgebaut ist, daß die kürzeren Schenkel von aneinanderstoßenden L-Profilen in entgegengesetzte Richtungen weisen, wobei die den kürzeren Schenkeln zugewandte Fläche der längeren Schenkel aufeinanderliegen. Vorzugsweise ist die Ausrichtung der kürzeren Schenkel bei erstem und zweitem Basisrahmen komplementär, und zwar insbesondere derart, daß die L-Profile der längeren (alternativ kürzeren) Rahmenseiten von miteinander verriegelten Basisrahmen ein geschlossenes Rechteckprofil bilden, in dem die verkämmten W-Profile gerade passend aufnehmbar sind, wobei die Seitenkanten der jeweils längeren Schenkel gegen die den längeren Schenkeln zugewandte Fläche der kürzeren Schenkel zum Anliegen kommen, siehe Fig. 2c and 2d. Durch diese Anordnung wird eine besonders sichere und spielfreie gegenseitige Zuordnung ermöglicht.

Es hat sich als besonders günstig erwiesen, wenn die L-Profile der kürzeren (alternativ längeren) Rahmenseiten von miteinander verriegelten Basisrahmen ein gespaltenes T bilden, wobei die beiden Hälften des gespaltenen T-Beins zum Rahmeninneren gerichtet sind und zwischen sich einen Schwenkhebel aufnehmen, der mit seinem aus dem T nach außen (bzw. oben) herausragenden Teil eine Handhabe für die Verriegelung bildet und mit seinem aus dem T nach innen (bzw. unten) herausragenden Teil an einem Verriegelungshebel angelenkt ist, um diesen Verriegelungshebel gegen Federkraft aus seiner Verriegelungsstellung herausschwenken zu können.

Dieser Verriegelungshebel wird vorzugsweise gemäß einer anderen Ausführungsform an seinem einen Ende nahe einer Rahmenecke angelenkt und von einer Feder in eine Endstellung gedrängt, in der er mit seinem anderen Ende sich an das aus L-Profilen gebildete Rechteckprofil derart anlegt, daß die W-Profile innerhalb des Rechteckprofils in Kämmstellung gehalten werden. Auf diese Weise wird die gewünschte Verriegelung erreicht.

Gemäß einer noch anderen Ausführungsform weisen die das Dach des T bildenden L-Profilschenkel Bohrungen zur Befestigung von Rack-Profilstücken auf. Natürlich sind aber auch andere Befestigungsarten denkbar.

Die Rack-Profilstücke von aufeinandergesetzten und verriegelten Rahmenmoduln weisen gemäß einer weiteren Ausbildung einen zur Gehäusefrontfläche bzw. Rückenfläche weisende Aufnahmeprofilschlitz zur Befestigung der Frontplatten von in die Rahmenmoduln eingeschobenen Geräten bzw. von Vor- und Rückwandteilen, Versteifungen o. dgl. auf.

Bei schweren Geräten kann es günstig sein, wenn je zwei Rack-Profilstücke an den Enden eines Rahmens durch je ein seitlich angeschraubtes Winkelstück versteift sind, welches Winkelstück gleichzeitig eine Gleitlagerung für das schwere Gerät bilden könnte.

Jedes Modul kann von einem Kofferelement gleicher Vertikalerstreckung umhüllt sein. Diese Kofferelemente können untereinander unt mit dem Case-Gehäuse-Kofferboden und mit einem Case-Gehäuse-Kofferdeckel mittels Schnappverschlüssen, Schmetterlingsverschlüssen, Aushängescharnieren oder dgl. verbunden sein und zusammen einen geschlossenen, ggf. Traggriffe und Laufrollen aufweisenden Behälter bilden.

Selbstverständlich können mehrere Kofferelemente auch zu einem einzigen Element zusammengefaßt werden, sowie es auch günstig ist, Kofferelemente verschiedener Höhe zur Verfügung zu haben, um so einen Behälter von jeweils günstigster Abmessung zusammensetzen zu können.

Um die Anordnung an einem Kofferboden (auch Bodendeckel genannt), Bodenaufsatz o. dgl. befestigen zu können, ist es günstig, wenn der obere Basisrahmen senkrecht zur Rahmenfläche verlaufende Bohrungen aufweist, beispielsweise in den Eckbereichen (Bodenrahmen).

Beim obersten Modul (Top-Modul im Gegensatz zu den übrigen "Stack-Moduln" genannten Moduln darunter) kann anstelle des aus L-Profilen bestehenden oberen Rahmens ein aus Rackschienen aufgebauter Rahmen vorgesehen sein. Je zwei der Rack-Profilstücke an den Ecken des Rackschienenrahmens können von einer linken und einer rechten, horizontal oder nach vorne abfallend angeordneten Seiten-Rack-Profilschiene starr verbunden sein, wobei deren Profil identisch mit dem der Rack-Profilstücke sein sollte und als deren geknickte Fortsetzung angeordnet sein sollten. Mit dieser Anordnung lassen sich dann in sehr einfacher Weise von oben zu bedienenden Tonbandmaschinen, Mischpulte o. dgl. griffgünstig anordnen.

Es soll nicht unerwähnt bleiben, daß das erfindungsgemäße Case-Gehäusesystem nicht nur für elektronische Geräte geeignet ist, die von Musikern benutzt werden, sondern auch für solche Geräte, die von Service- oder Meßtrupps von Ort zu Ort transportiert werden müssen, oder auch für Geräte, die für die Luftüberwachung und die Messung von Schadstoffgehalten in Luft und Wasser eingesetzt werden. Auch im medizinischen Bereich gibt es zahlreiche Anwendungsfälle, so Notarzteinrichtungen, die Meß- und Hilfsgeräte elektronischer Art umfassen.

Die Erfindung wird nachfolgend anhand von Ausführungsbeispielen näher erläutert, die in den Zeichnungen dargestellt sind.

Es zeigt:

Fig. 1 in zwei Teilfiguren 1a und 1b in einer auseinandergezogenen Darstellung ein Grundmodul des erfindungsgemäßen Rahmensystems, bestehend aus einem ersten (oberen) und zweiten (unteren) Basisrahmen, verbunden über mittels Klemmschrauben angebrachter Rack-Profilstücke;

Fig. 2 in zwei Teilfiguren 2a und 2b eine Ansicht von unten auf den zusammengesetzten Modul bzw. eine Seitenansicht auf diesen Model, in Teilfiguren 2c und 2e eine Schnittansicht senkrecht durch die W-Profile zur Darstellung der Verkämmung der W-Profile zur Kraftaufnahme in horizontaler Tiefenrichtung; in Teilfiguren 2e und 2f Schnittzeichnungen parallel zu den W-Profilen in geschlossener und abgetrennter Stellung zur Darstellung der Kraftaufnahme parallel zur Frontfläche (horizontal) und in Teilfigur 2g in vergrößertem Maßstab die verkämmten W-Profile.

Fig. 3 in Teilfiguren a, b, c, d, e die einzelnen Teile 1 bis 14, aus denen der Modul gemäß Fig. 1 und 2 aufgebaut werden kann;

Fig. 4 in Teilfiguren a, b, c eine genauere Darstellung des Rack-Profils;

Fig. 5 eine näher ins einzelne gehende, auseinandergezogene Darstellung des Verriegelungssystems;

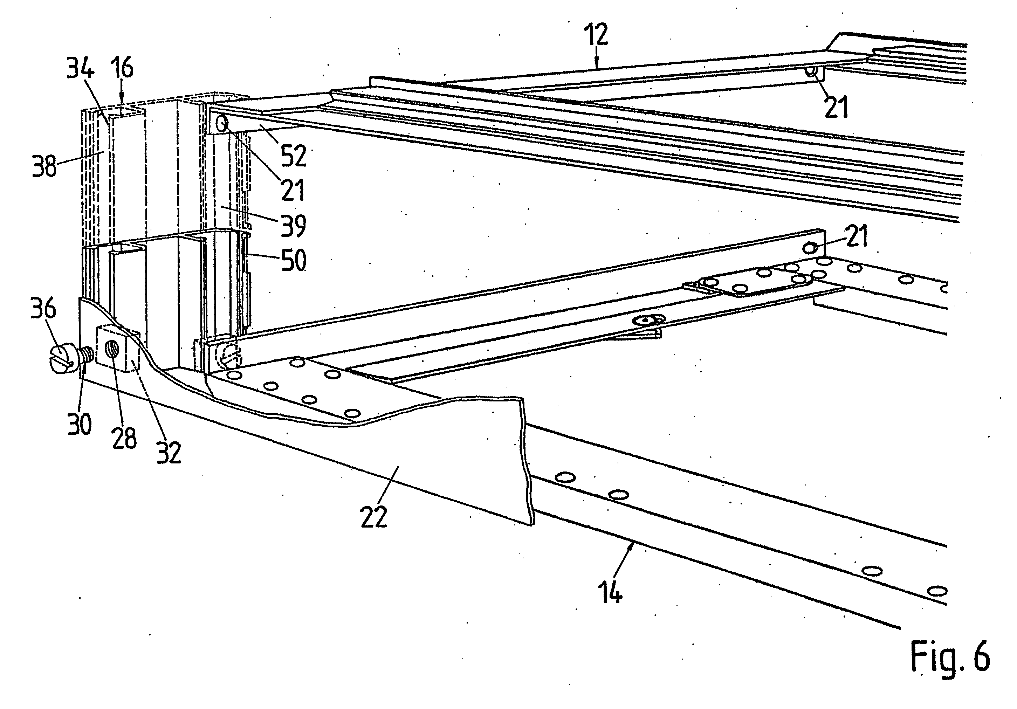

Fig. 6 eine ähnliche Darstellung wie Fig. 1a, jedoch in zusammenhängendem Zustand;

Fig. 7 eine perspektivische Darstellung eines in ein Gehäusesystem gemäß Fig. 1 eingesetztes Gerät;

Fig. 8 ein aus mehreren Teilen bestehendes kofferartiges Umhüllungssystem sowie die zugehörigen Moduln;

Fig. 9 einen Aufsatz für von oben zu bedienende Geräte; und

Fig. 10 eine Detaildarstellung der Kofferumhüllung.

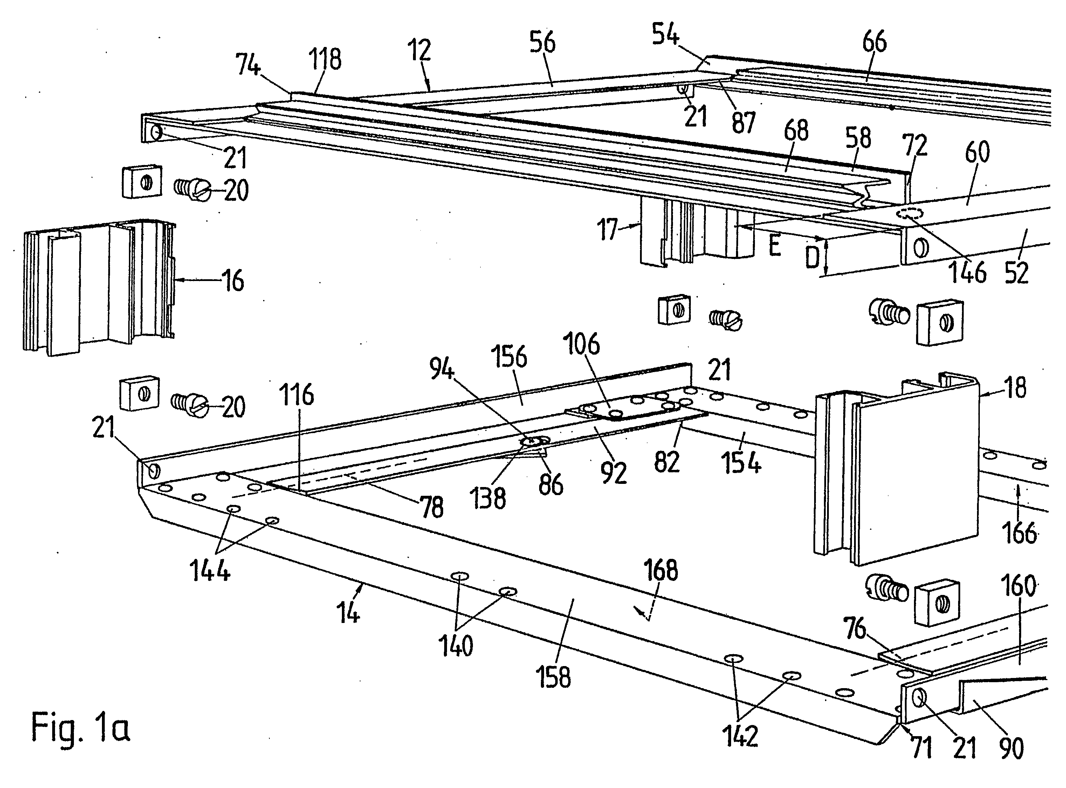

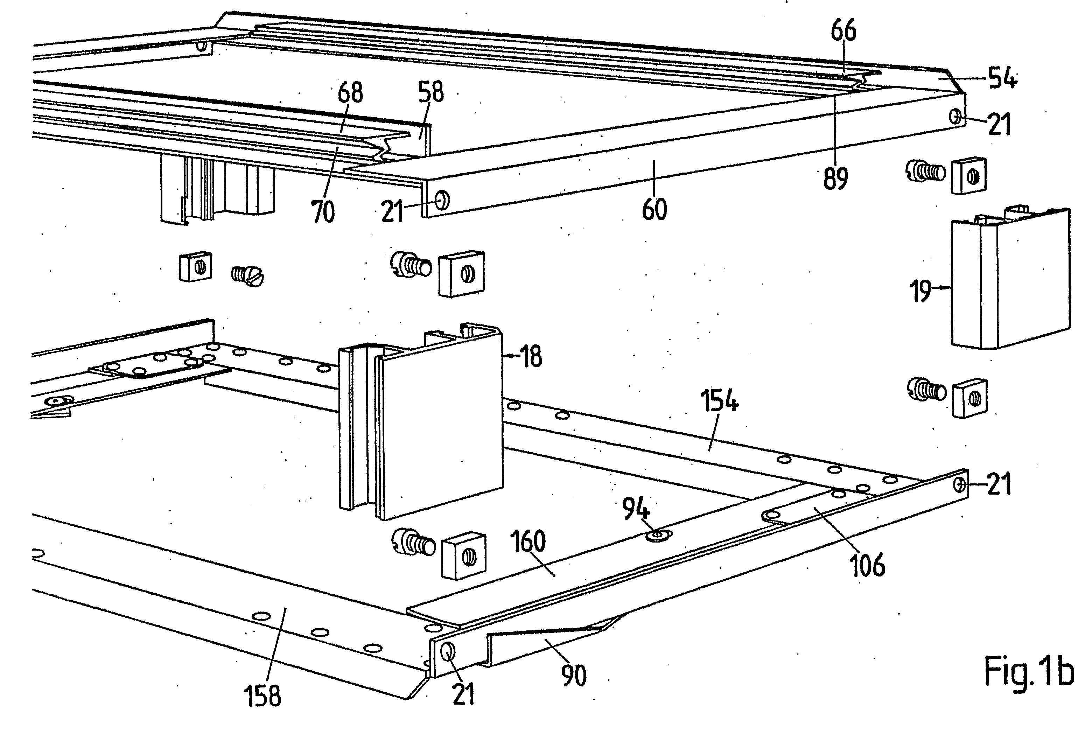

In Fig. 1 ist in den Teilfiguren 1a und 1b in einer auseinandergezogenen Darstellung ein erfindungsgemäß gestalteter Rahmenmodul zum Aufbau eines Case-Gehäusesystems wiedergegeben, wobei der Rahmenmodul 10 einen ersten oder oberen Basisrahmen 12 und einen zweiten oder unteren Basisrahmen 14 umfaßt, die über vier Rack-Profilstücke 16, 17, 18 und 19 mit Hilfe von Klemmverschraubungen 20 starr verbindbar sind und dann ein Einschubgehäuse für ein elektronisches Gerät bildetem, wobei die Länge der Rack-Profilstücke 16 bis 19 je nach Höhe des einzuschiebenden Gerätes unterschiedlich gewählt ist.

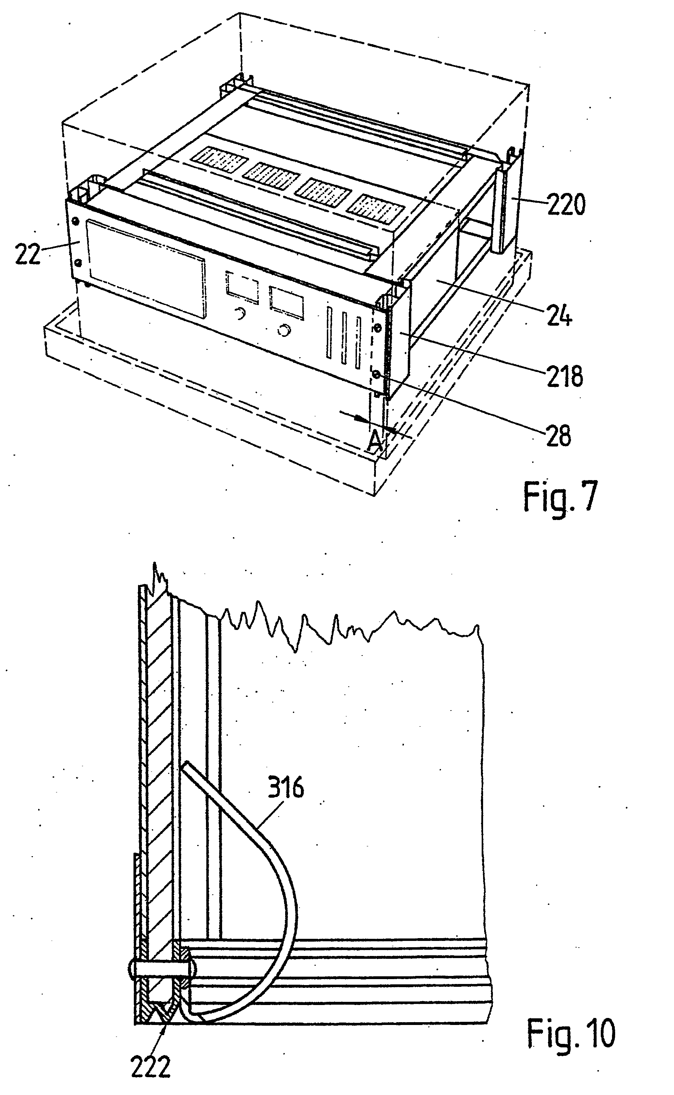

Diese Geräte, von denen eins mit der Bezugszahl 24 in Fig. 7 dargestellt ist, besitzen üblicherweise eine Frontplatte 22, die rechts und links über die Innengehäusemaße ("Einbaubreite") des Gerätes 24 um ein Stück A hinausragen und in diesem Bereich Durchbrüche 28 besitzen, um die Frontplatte 22 und damit das Gerät 24 an entsprechenden Metallprofilen 16 wiederum mit Hilfe einer Klemmverschraubung 30 zu befestigen, die üblicherweise aus einer Vierkantmutter 32 besteht, die in ein entsprechend geformtes T-förmiges Innenprofilteil 34 einschiebbar ist, so daß eine Schraube 36 durch die Bohrung 28 der Frontplatte 22 sowie den Profilschlitz 38 hindurchgesteckt und in die Vierkantmutter 32 eingeschraubt werden kann. Auf diese Weise ist eine höhenveränderliche Klemmverschraubung erreichbar. Anstelle einer einfachen Vierkantmutter kann auch eine sogenannte Käfigmutter verwendet werden, die sich im Profil festhält, auch wenn der zugehörige Schraubbolzen 36 entfernt ist.

Andere Befestigungsarten sind selbstverständlich auch denkbar, beispielsweise ein Hohlprofil oder Winkelprofil mit Gewindelöchern, bei dem allerdings keine kontinuierliche Verstellbarkeit vorhanden ist, sondern nur eine Verstellbarkeit in Schritten in den Abständen der Gewindelöcher.

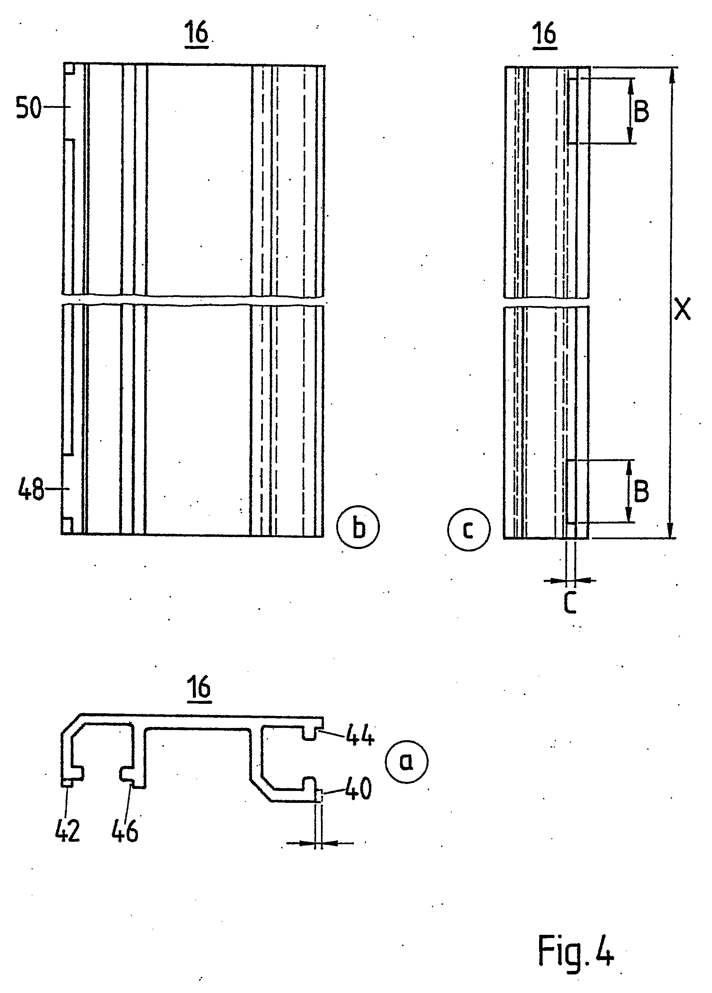

Das hier dargestellte besonders günstige Profil ist in Fig. 4 nochmals in vergrößertem Maßstab gegenüber den anderen Figuren in der Teilfigur a in Querschnittsansicht dargestellt, wobei es sich zunächst um ein im Handel erhältliches Profil handelt, bei dem jedoch zur besseren Passung jeweils ein Vorsprung 40 bzw. 42 abgefräst ist, um so eine Anlagepassung in der Ecke 44 bzw. 46 zu erhalten.

Die Abfräsung wird an der einen Kante vorzugsweise auf einen Bereich 48 bzw. 50 begrenzt, siehe die Teilfigur b, wobei die Breite des abgefrästen Bereiches 48 bzw. 50 die Breite des entsprechenden Schenkels 52 eines L-Profils besitzt, aus der der jeweilige Rahmen 12 bzw. 14 zusammengesetzt ist. Dies ergibt durch Formschlüssigkeit eine zusätzliche Versteifung in Vertikalrichtung. Dies betrifft den Vorsprung 42 der Fig. 4a, während der Vorsprung 40 vorzugsweise in seiner gesamten Länge beseitigt wird, da in diesem Bereich die Frontplatte 22 in voller Länge aufliegen soll. Zu erkennen ist dies aus der Fig. 4b, die eine Ansicht von unten auf die Profilschiene der Fig. 4a darstellt, sowie aus der Fig. 4c, die eine Ansicht von links auf die in Fig. 4a dargestellte Schiene ist. Durch dieses Merkmal ergibt sich eine Frontplattenkantenanlage in der von dem verbleibenden Vorsprung gebildeten Ecke und ergibt dadurch eine Versteifung gegenüber parallelogrammartiger Verwindung bei u. U. nicht ganz festgezogenen Klemmschrauben.

Die Erstreckung der Einschnitte 48 bzw. 50, hier mit B bezeichnet, entspricht dabei der entsprechenden Schenkellänge D des L-Schenkelteils 52, während die Einschnittiefe C gleich der Höhe des Vorsprungs 40 und so gewählt ist, daß das Schenkelteil 52 an den beiden T-Beinen anliegt, damit Parallelität der Rack- Profilstücke (in horizontaler Tiefenrichtung) gewährleistet ist.

Die Höhe des Rack-Profilstückes 16, in Fig. 4c mit X bezeichnet, hängt, wie bereits erwähnt, von der aufzunehmenden Gerätehöhe ab.

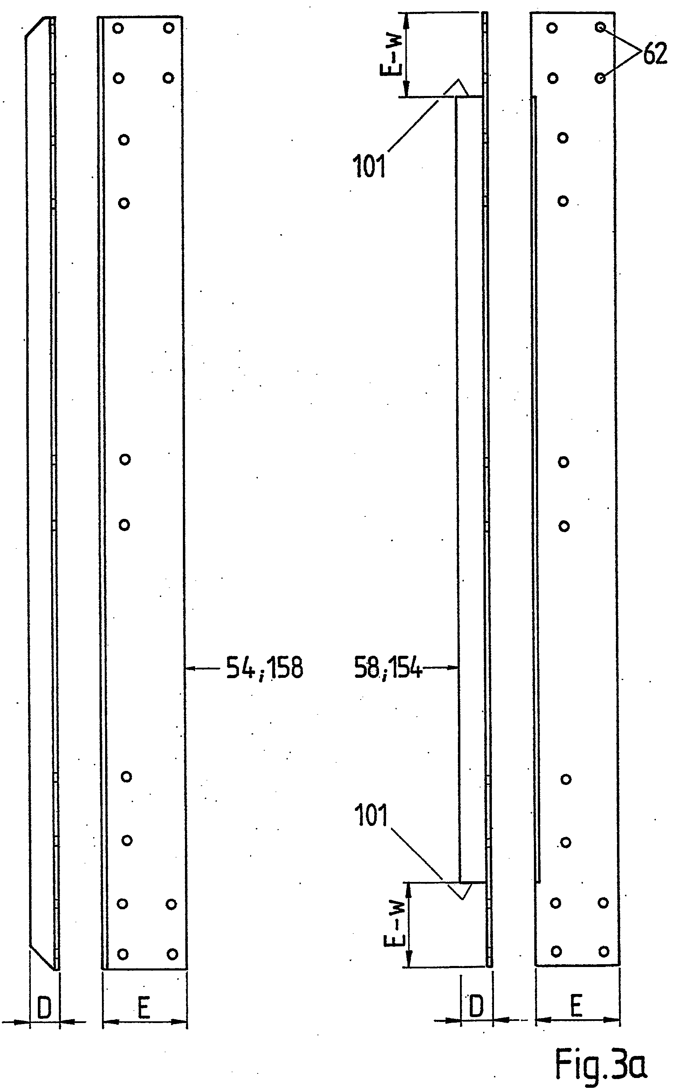

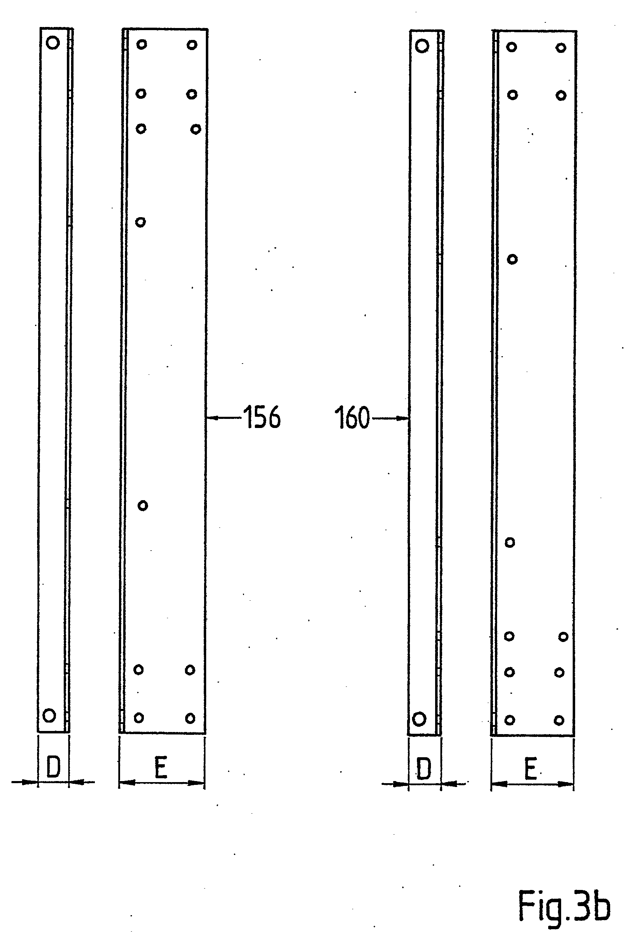

Unterer wie auch oberer Basisrahmen 12 bzw. 14 sind, wie beispielsweise der Fig. 1 entnommen werden kann, jeweils aus vier L-Profilstücken 54, 56, 58 bzw. 60 (bzw. 154, 156, 158 und 160) aufgebaut, die zweckmäßigerweise jeweils die gleiche Querschnittsform mit jeweils unterschiedlichen Schenkellängen D und E aufweisen, siehe z. B. die Fig. 1a sowie die Teilfiguren 3a, 3b, und 3c. In der Fig. 3a sind die L-Profile 54 (links) bzw. 154 (rechts) dargestellt, das sind die hinteren L-Profile des oberen bzw. unteren Rahmens 12 bzw. 14. Demgegenüber zeigen die Fig. 3b die L-Profile 156 bzw. 160, das ist das linke bzw. rechte Seiten-L-Profil des unteren Rahmens, während das vordere L-Profil 158 des unteren Rahmens 14 dem hinteren L-Profil 54 des oberen Rahmens 12 entspricht, siehe den linken Teil der Fig. 3a, und das vordere L-Profil 58 des oberen Rahmens 12 dem hinteren L-Profil 154 des unteren Rahmens 14.

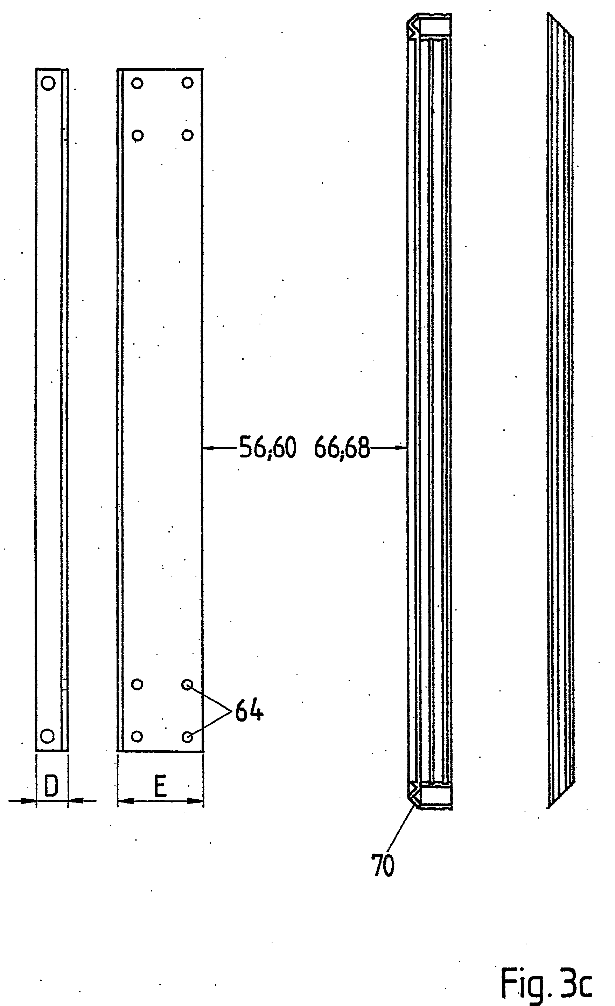

Schließlich zeigt die Fig. 3c in ihrer linken Hälfte das L-Profil der identisch aufgebauten seitlichen L-Profile des oberen Rahmens 12, Bezugszahlen 56 bzw. 60.

Es zeigt sich, daß bestimmte Rahmenteile identischen Aufbau haben, was einer verbilligten Fertigung zugute kommt, abgesehen von der Tatsache, daß wegen der identischen Querschnittsprofilform das gleiche Profilmaterial für alle Rahmenleisten verwendbar ist.

Wie der Fig. 1 beispielsweise zu entnehmen ist, werden die L-Profile zur Bildung der Rahmen 12 bzw. 14 derart zusammengestellt, daß die längeren Schenkel (Länge E) an den Rahmenecken derart aufeinandergelegt sind und zwar derart, daß der kürzere Schenkel der L-Profilleiste 58 senkrecht nach oben, siehe Fig. 1a, steht, während der entsprechende Schenkel der Leiste 60 senkrecht nach unten gerichtet ist, und beispielsweise durch Nieten, Kleben oder Schweißen verbunden sind, wobei die kürzeren Schenkel (Maß D) von aneinanderstoßenden L-Profilen, beispielsweise Profile 58, 60 in entgegengesetzte Richtungen weisen, wobei die im rechten Winkel aufeinanderliegenden L-Profile mit den Stirnflächen in ihren Kehlen aneinanderstoßen, siehe Bezugszahl 71 in Fig. 1a, was folgende Vorteile hat:

1. Durch Fertigungspräzision bei der Endmontage ergibt sich eine gegenseitige Verschachtelung und ein Ineinandergreifen, was die Stabilität und Verwindungssteifigkeit erhöht.

2. Es ergibt sich ein Aufnahmeraum für den Verriegelungshebel 92 in der gleichen Ebene, in der die längeren Schenkel der L-Profile 158 bzw. 154 liegen, wodurch sich eine sehr einfache Arretierung mittels dieses Hebels 92 ergibt, siehe Fig. 2d.

3. Die Anordnung ist sehr platzsparend, weil nur die Handhabe 90 des Schwenkhebels 86 in den Außenraum des Rahmens hinausragt, während andererseits die nach innen ragenden verriegelnden Teile (Verriegelungshebel 92) das Einführen von Geräten in den Rahmenmodul nicht behindern, abgesehen ggf. von der Platte 106 und dem Niet 94 mit Unterlegscheibe 138, siehe Fig. 1.

4. Der Zwischenraum zwischen zwei Geräten ist auf die kleinere Schenkellänge D minimiert, siehe Fig. 2d, so daß die erfindungsgemäße Modulbauweise nur eine zusätzliche Stapelerhöhung von dieser Schenkellänge D pro Modul ergibt.

5. Blockierung in horizontaler Richtung parallel zu den U-Profilschienen 66, 68.

Die übereinander liegenden Schenkelteile sind beispielsweise durch Vernietung über Bohrungen 62, 64 in den Teilen 58 bzw. 60 fest miteinander verbunden.

Anstelle der Vernietung kann natürlich auch eine Verklebung, Verschweißung oder sonstige Fixierung treten.

Die Figuren lassen außerdem erkennen, daß jeweils zwei parallele (es sind hier die längeren) Seiten der Leisten mit aufgesetzten U-Profilen versehen sind, die in der Fig. 3c auf der rechten Seite dargestellt sind. Diese U-Profile, auch als Schließprofile bezeichnet, besitzen ein W-förmig ausgebildetes U-Steg-Profil, wie durch das Anschneiden um 45° in der Fig. 3c deutlich zu erkennen ist. Diese W-Profilierung 70 ist dabei derart angeordnet, daß beim verriegelnden Zusammenbau eines oberen Basisrahmens 12 eines ersten Moduls mit einem unteren Basisrahmen 14 eines darübergesetzten zweiten Moduls die W-Profile 66 und 68 der beiden Rahmen kammartig ineinandergreifen und dadurch eine Verriegelung in vertikaler Richtung ergeben.

Die Blockierung in horizontaler Richtung parallel zu den U-Profilschienen 66, 68 erfolgt dadurch, daß die Stirnkanten 72 des L-Profils 58 des oberen Rahmens 12 mit den entsprechenden Seitenkanten 76 bzw. 78 der L-Profile 160 bzw. 156 des unteren Rahmens 14 eines aufgesetzten Moduls in Eingriff kommen. Zu diesem Zweck muß das in Fig. 3a rechts gezeigte L-Profilstück 58 bzw. 154 an beiden Enden auf einer Länge (E - W), wobei W die Wandstärke des L-Profilstücks ist, von dem kürzeren Schenkel befreit werden, so daß sich eine rechtwinklig abstehende Anlagefläche 101 ergibt. Entsprechend gehen die Stirnflächen des kürzeren und damit vorspringenden L-Schenkels des L-Profils 154, 82 bzw. 84 (letztere Kante in Fig. 1a nicht erkennbar) des unteren Rahmens 14 mit entsprechenden Kantenflächen 87 bzw. 89 des oberen Rahmens 12 eines unteren Moduls in Eingriff.

Es verbleibt noch die Arretierung in horizontaler Richtung parallel zu den seitlichen L-Profilschienen 56, 60 bzw. 156, 160 (in Richtung auf die W-Profilierung) für die eine spezielle Hebelarretierung vorgesehen ist, die im folgenden nun näher beschrieben werden soll.

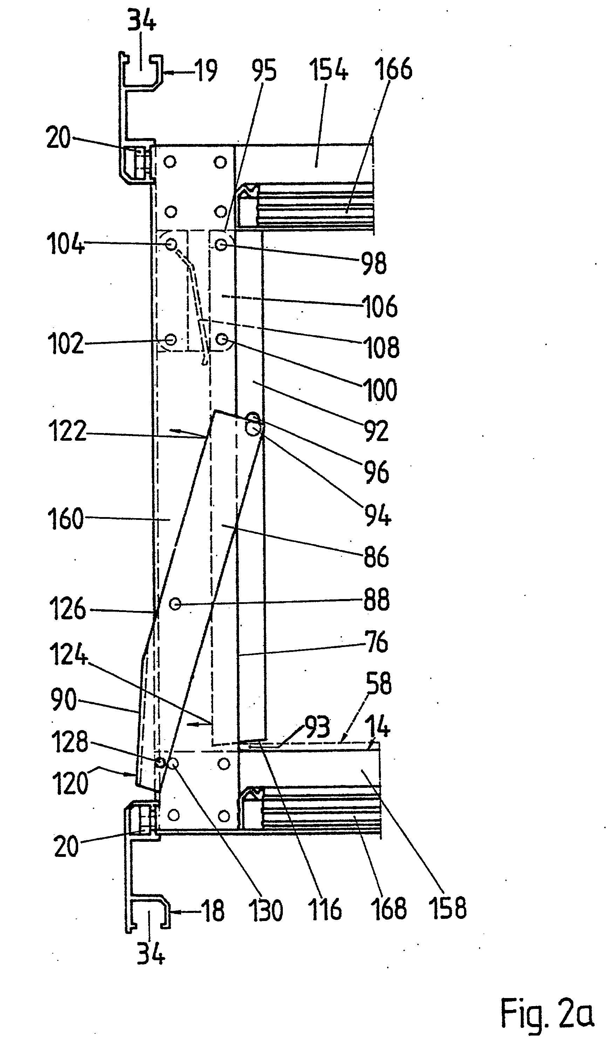

Zu diesem Zweck sei auf die Fig. 2a verwiesen, in der der entsprechende Mechanismus deutlich zu erkennen ist. Er besteht aus jeweils einem auf den seitlichen L-Profilen 156 bzw. 160 angelenkten Schwenkhebel 86, der um einen Drehpunkt 88, beispielsweise in Form einer Vernietung, auf der von dem kürzeren Schenkel des L-Profils abgewandten Seite des längeren Schenkels drehbar aufgesetzt ist. Die Anordnung ist dabei derart, daß die entsprechenden L-Profile der (bei der dargestellten Ausführungsform kürzeren) Rahmenseiten 56 bzw. 156 von miteinander verriegelten Basisrahmen 12 bzw. 14 zweier verschiedener Moduln ein gespaltenes T bilden, wobei das gespaltene T-Bein zum Rahmeninneren gerichtet ist und zwischen sich soviel Spiel läßt (dies läßt sich durch entsprechende Form und Anordnung der U-Profile 66, 68 des oberen Rahmens 12 bzw. 166, 168 des unteren Rahmens 14 ohne weiteres erreichen), daß der Schwenkhebel 86 in dieser Spalte frei beweglich bleibt.

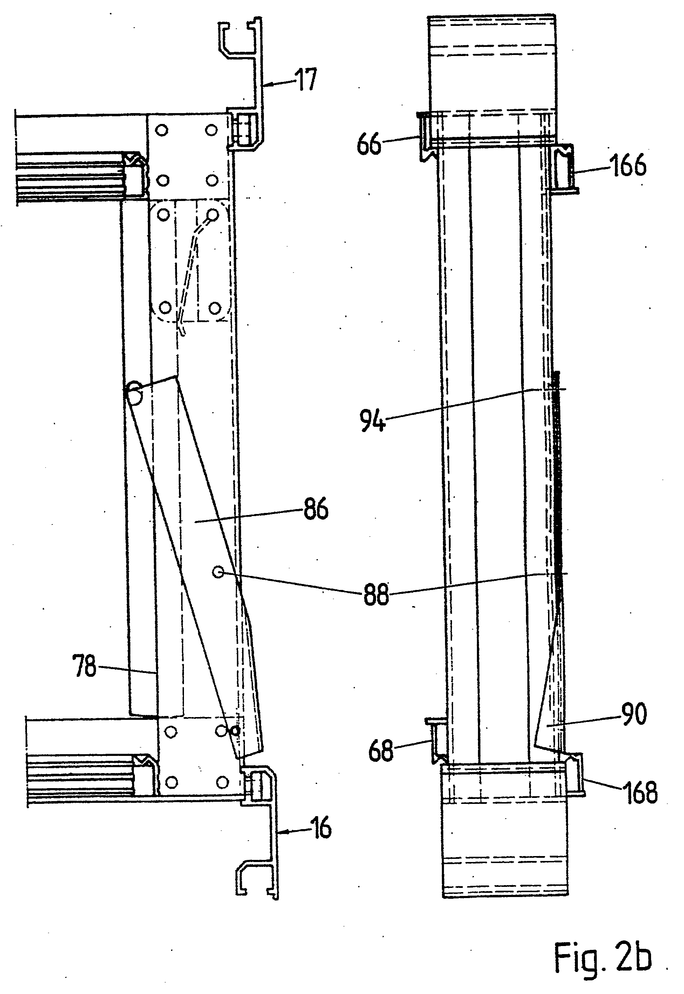

Wie die Fig. 2b erkennen läßt, besitzt der Schwenkhebel 86 an seinem aus dem T nach außen herausragenden Teil eine Art Handhabe 90, die durch einfaches Umbiegen des herausragenden Teils des aus einem rechteckförmigen Blechstreifen gebildeten Schwenkhebels 86 gebildet sein kann.

Mit seinem anderen, wiederum aus dem T, jetzt jedoch nach innen herausragenden Teil, ist der Schwenkhebel 86 an einem sogenannten Verriegelungshebel 92 über einen Anlenkpunkt 94 angelenkt, wobei die Anlenkung eine geringfügige axiale Verschiebung bezüglich der Längserstreckung des Verriegelungshebels 92 erlaubt, beispielsweise dadurch, daß ein vom Anlenkungspunkt 94 des Schwenkhebels 86 ausgehender Stift in ein Langloch 96 innerhalb des Verriegelungshebels 92 hineinreicht. Der Verriegelungshebel 92 ist seinerseits an seinem einen Ende nahe einem (vom Schwenkhebel 86 entfernten) Ende des L-Profils 156 angelenkt, und zwar an der zum kürzeren Schenkel des L-Profils gerichteten Fläche des längeren Schenkels des L-Profils, siehe den Anlenkpunkt 98 in Fig. 2a. Der Verriegelungshebel 92 liegt dabei in seiner verriegelnden Ruhestellung mit seiner geraden Stirnfläche 95 (nahe seinem Anlenkpunkt 98) an der dem längeren Schenkel des L-Profils 154 abgewandten Fläche des kürzeren Schenkels, 118, an. Die Anlenkung kann wiederum mit Hilfe eines Niets erfolgen. Dieser Niet hält gleichzeitig, zusammen mit weiteren Nieten 100, 102, 104 eine Halteplatte 106 für eine kurze Drahtfeder 108, die gegen die eine Seitenkante des Verriegelungshebels 92 drückt und diesen in seine in Fig. 2a dargestellte Verriegelungsstellung drängt, in der er sich mit seiner am Drehpunkt befindlichen Stirnfläche an die entsprechende Seitenfläche 118 des kürzeren Schenkels der L-förmigen Schiene 154 anlegt und mit seiner vom Drehpunkt 98 abgewandten Stirnfläche 116 an die entsprechende Seitenfläche 118 des kürzeren Schenkels der L-förmigen Schiene 58 des oberen Rahmens 12 eines darunter befindlichen Moduls verriegelnd anlegt. Diese Stellung ist in Fig. 2a wiedergegeben. Drückt man nun auf die Handhabe 90 des Schwenkhebels 86, dreht sich dieser um den Drehpunkt 88 in Richtung des Pfeils 120 bzw. 122 und nimmt damit über den Stift 94, der in das Langloch 96 des Verriegelungshebels 92 hineinreicht, den Verriegelungshebel mit und verschwenkt diesen um den Drehpunkt 98 in Richtung des Pfeils 124, gegen die Kraft der Feder 108. Wenn der umgebogene Teil, also die Handhabe 90 des Betätigungshebels 86 grade den Rand 126 des L-Profils 160 erreicht hat, hat sich der Verriegelungshebel 92 um seinen Drehpunkt 98 soweit in Richtung des Pfeils 124 verschwenkt, daß die Stirnfläche 116, die einen Krümmungsradius R um den Anlenkpunkt 98 besitzt, und einen Spalt 93 zur Aufnahme des kürzeren Schenkels des L-Profils 58 mit der engsten Spaltweite W an der Stelle 76 bzw. 78 in Fig. 1a, welche Stelle sich durch das Maß E - W ergibt, unterhalb des längeren Schenkels des L-Profils 160 verschwunden ist und damit die Seitenfläche 118 freigegeben hat. Der untere Rahmen 14 kann nun bezüglich des oberen Rahmens 12 eines unteren Moduls nach vorne gezogen werden, wodurch seine W-Profile 166 bzw. 168 aus den entsprechenden W-Profilen 66, 68 des anderen Moduls freikommen und eine Trennung der beiden Moduln voneinander ermöglichen.

Es ist zweckmäßig, diese Freigabestellung in geeigneter Weise fixierbar zu machen, um die Handhabung der Anordnung zu erleichtern. Die Fixierung kann beispielsweise dadurch geschehen, daß an dem die Handhabe 90 aufweisenden Ende des Schwenkhebels 86 eine Bohrung 128 derart angeordnet wird, daß diese Bohrung im entriegeltem Zustand des Schwenkhebels 86 genau über dem Befestigungsniet 130 zum Liegen kommt, so daß dieser Niet 130 in die Bohrung 128 einrastet und den Hebel 86 trotz des Drucks der Feder 108 festhält. Durch leichtes Anheben des Schwenkhebels 86 mittels der Handhabe 90 (bezüglich Fig. 2a aus der Zeichenebene heraus) läßt sich die Bohrung 128 aus dem Nietdorn des Niet 130 wieder lösen, woraufhin die Feder 108 die Anordnung wieder in ihre Verriegelungsstellung drückt, die in der Fig. 2a dargestellt ist.

Falls die Verbindung der einzelnen L-Profile nicht mittels Nieten erfolgt, sondern durch Kleben, Schweißen oder auf andere Weise, könnte für diesen speziellen Zweck eine vorspringende Nase 130 aus dem Material herausgedrückte werden, um den gleichen Zweck zu erfüllen.

Die Fig. 2a läßt auch die Befestigung des unteren Rahmens 14 an den Rack-Profilstücken 18 und 19 mit Hilfe von Klemmverschraubungen 20 erkennen, außerdem wird deutlich, wie an dem Rack-Profilstück 18 eine Frontplatte und ein Rack-Profilstück 19, eine Rückwand oder dgl. durch Einschieben von entsprechenden Klemmverschraubungen 30 in das Innenprofil 34 befestigt werden können

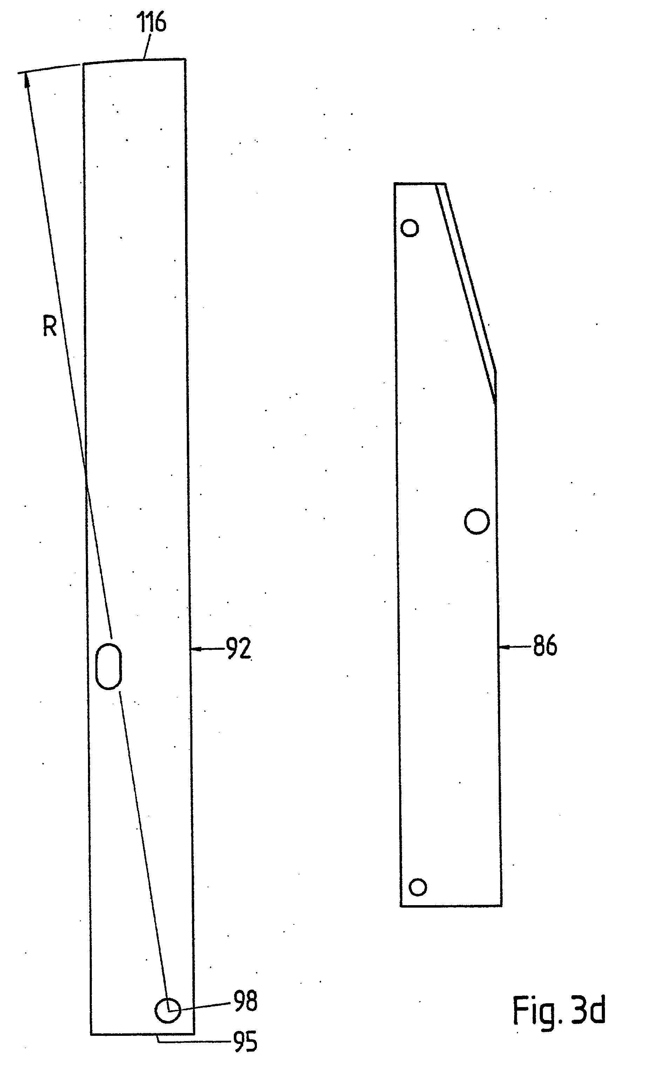

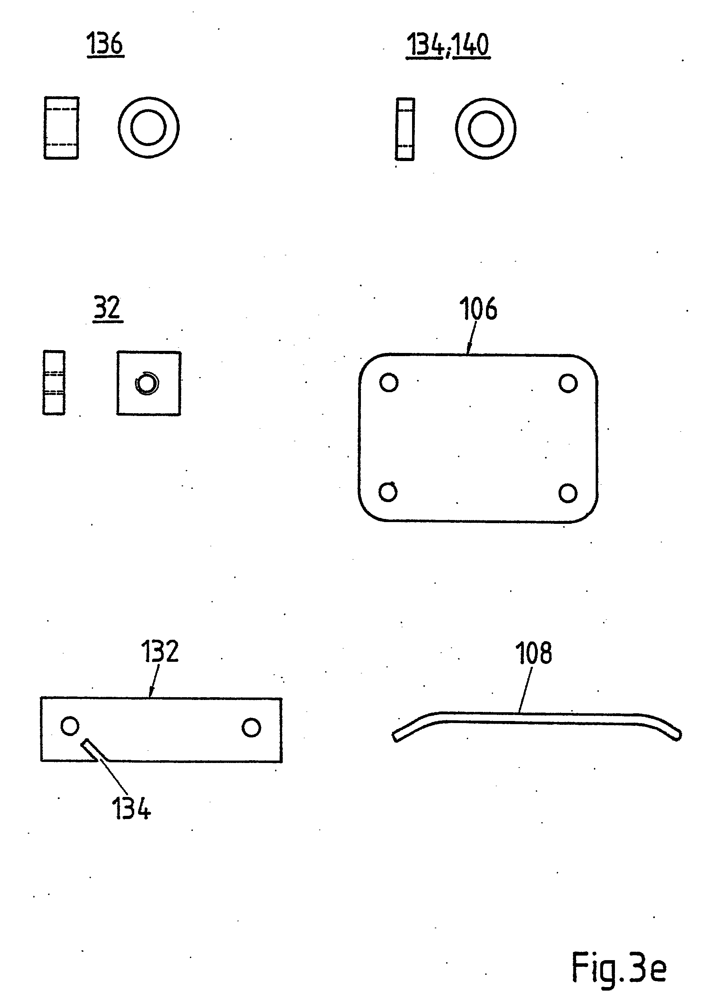

Es sei noch erwähnt, daß in der Fig. 3d links der Verriegelungshebel und rechts der Schwenkhebel dargestellt sind, während in Fig. 3e die Halteplatte 106 zu erkennen ist, wie auch die Drahtfeder 108, die von einer Federhalteplatte 132 gehalten wird, indem die Feder 108 in einen Schlitz 134 eingeschoben wird, wobei die Feder einerseits von den zwei Wänden dieses Schlitzes 134, andererseits von der Halteplatte 106 bzw. von der inneren Fläche des längeren Schenkels des L-Profils gehalten wird, auf dem die Halteplatte 106 aufgesetzt ist. Dabei ist der Durchmesser des Federdrahtes 108 etwas geringer als die Dicke der Federhalteplatte 132, so daß sich die Feder 108 zwischen der Halteplatte 106 und dem L-Profil frei verschwenken kann.

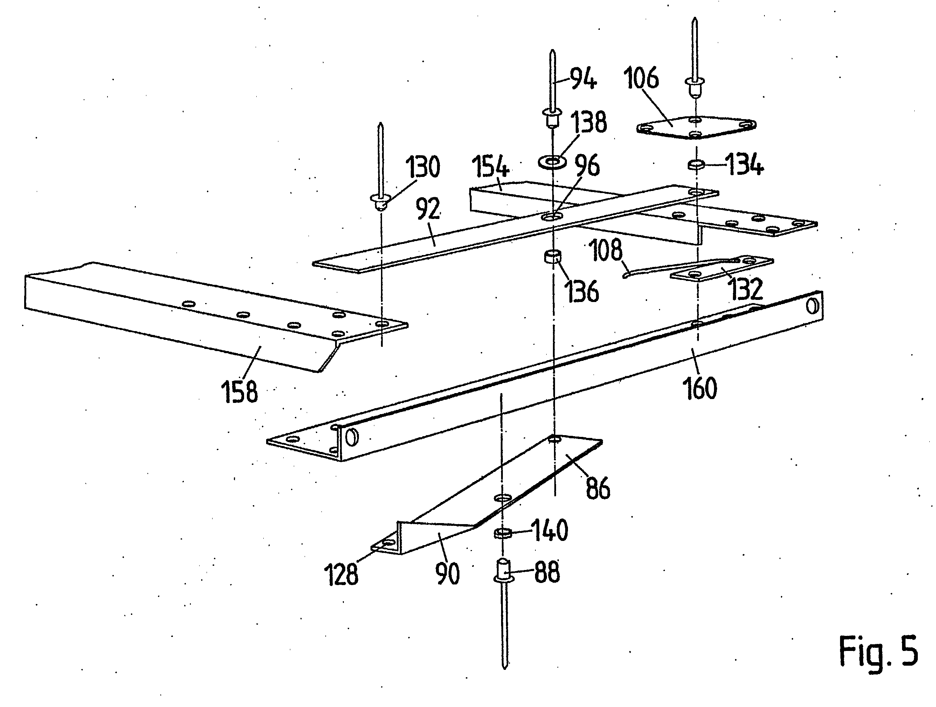

In Fig. 5 wird dieser Aufbau noch einemal in einer auseinandergezogenen Darstellung näher erläutert. Als zusätzliche Bauteile sind hier noch eine Abstandshülse 134, und eine weitere Abstandshülse 136 zu erkennen, die gleichfalls dazu dienen, eine freie Beweglichkeit des Verriegelungshebels 92 sicherzustellen, außerdem ist noch eine Beilagscheibe 138 zu erkennen, die eine sichere Lagerung des Verriegelungshebels 92 hinsichtlich des Langlochs 96 sicherstellt. Die Abstandshülsen 134 bzw. 136 weisen unterschiedliche Länge auf, bedingt dadurch, daß die Abstandshülse 136 durch den Verriegelungshebel 92 reichen muß und auch die durch die Wandstärke w des seitlichen L-Profils 160 bzw. 156 vorgegebene Distanz bis zum Schwenkhebel überwindet, während die Abstandshülse 134 nur dem Verriegelungshebel 92 freies Spiel gewähren muß.

Auch die weitere Abstandshülse 140, die zur Schwenklagerung des Schwenkhebels 86 dient, hat die kürzeren Ausmaße der Abstandshülse 134. Die Längen der Abstandshülsen ergeben sich wie folgt: Die Hülsen 134 bzw. 140 besitzen eine der Wandstärke des Hebels 92 plus Spiel entsprechende Länge. Die Hülse 136 besitzt dagegen eine Länge, die den Wandstärken von Hebel und Wandstärke w des L-Profils, plus Spiel, entspricht.

Wie aus der vorhergehenden Beschreibung deutlich geworden ist, stellt das erfindungsgemäße Gehäusesystem eine sehr vielseitige Anordnung dar. Insbesondere ist es möglich, das Gehäusesystem an Geräte unterschiedlicher Höhe anzupassen.

Dies erlaubt eine schnelle Vereinigung und Trennung von einzelnen Gehäuseteilen mit zugehörigen Einschubgeräten, ermöglicht aber auch das Einschieben von Geräten sowohl von vorne wie auch von hinten, da auch auf der Hinterseite durch die dort angeordneten Rack-Profile mit nach hinten offenen Befestigungsnuten Geräte eingeschoben und über ihre Frontplatten an dem Gehäusesystem befestigt werden können. Dies ist dann von besonderer Bedeutung, falls die Geräte unterschiedliche Tiefe besitzen, derart, daß beispielsweise bei in einem Modul eingeschobenem Gerät hinter diesem Gerät ausreichend Platz bleibt, um ein zweites Gerät von entsprechend geringerer Tiefe von hinten in die Anordnung einzuschieben, wobei dieses zusätzliche Gerät beispielsweise ein Umsetzer, Verstärker, Netzgerät oder dgl. sein könnte, das nicht regelmäßig bedient werden muß. Alternativ kann an den Rack-Profilen auch eine Rückwandplatte angeschraubt werden, auch ein Anschlußfeld. Alles dies kommt einer Bauhöhenreduzierung zugute.

Wenn man sich erneut die Fig. 1 betrachtet, erkennt man Bohrungen, die in den längeren Schenkeln der vorderen und hinteren L-Profile des unteren Basisrahmens angeordnet sind, die also senkrecht zur Rahmenfläche verlaufen und hier die Bezugszahlen 140, 142 und 144 tragen. Diese Bohrungen dienen vorzugsweise zur Befestigung der U-Profilschiene 168 an dem L-Profil 158. Nur bei bestimmten Verwendungszwecken können weitere Bohrungen 146 insbesondere im oberen Basisrahmen 12, vorzugsweise an den Ecken, vorgesehen sein, und zwar dann wenn eine Befestigung dieses oberen Basisrahmens an einen Kofferboden, an einen Bodenaufsatz oder dgl. vorgesehen sein soll. In diesem Falle würde der "obere" Basisrahmen der am tiefsten angeordnete Basisrahmen sein, auf den dann der untere Basisrahmen eines ersten Moduls verriegelnd aufgesetzt werden kann.

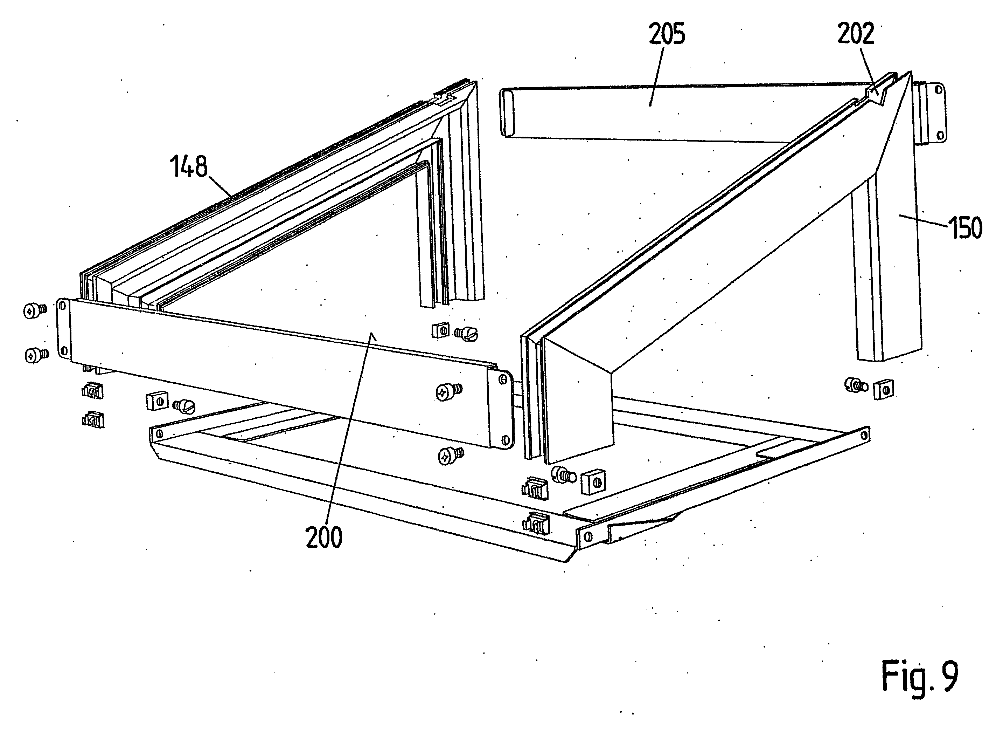

Auf dem letzten in der beschriebenen Weise aufgebauten Modul kann dan ein anders gestalteter Modul als oberer Abschluß aufgesetzt werden, beispielsweise bestehend aus einem unteren Basisrahmen 14, auf dem dann ein Tonbandgerät, ein schräg verlaufendes Mischpult, oder andere Geräte mit oberseitigen Bedienungs- oder Anzeigeflächen aufgesetzt werden kann. Das bedeutet, daß bei diesem obersten Gerät der obere Basisrahmen 12 nicht mehr vorhanden ist, sondern statt dessen an dem unteren Basisrahmen 14 anstelle der üblichen geraden Rack-Profilstücke 16, 17 bzw. 18 19 zwei gemäß der Fig. 9 aufgebaute Rack-Profilbügel 148, 150, auf die eine Frontplatte 200 aufgesetzt und in üblicher Weise in den Profilschienen zu den Profilen mit Klemmverschraubungen befestigt werden kann. Auf der Hinterseite können bei Bedarf Versteifungsschienen 205 (nicht dargestellt) in ganz analoger Weise angebracht werden.

Es sei noch erwähnt, daß es je nach Art der Klemmverschraubungen unter Umständen günstig sein kann, an einem Ende des Rack-Profilbügels 148 oder 150 einen schrägen Einschnitt, als Kerbe oder Nut ausgelegt, beispielsweise in der Form gemäß Bezugszahl 202 anzubringen, um dort Klemmverschraubungen einschieben zu können.

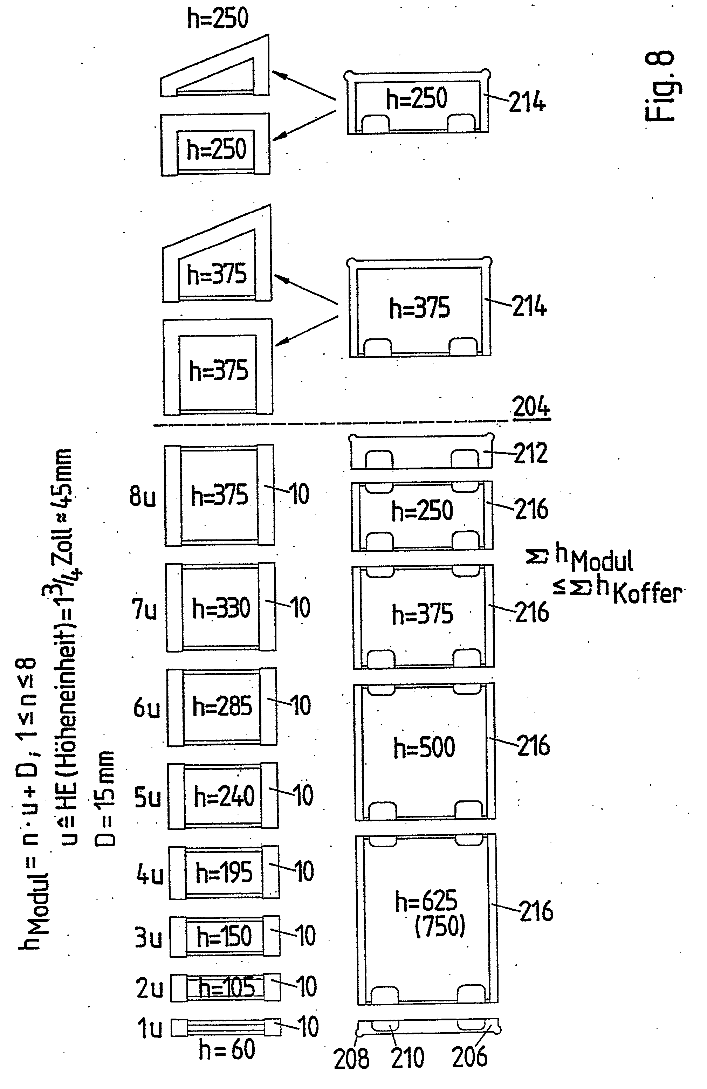

Es wurde bereits erwähnt, daß mittels Bohrungen 146 im oberen Basisrahmen 12 dieser an ein Fundament, Kofferboden, o. dgl. befestigbar ist. Bei dem Kofferboden kann es sich um einen an sich bekannten Case-Gehäusekoffer 104 handeln, wie er in Fig. 8 dargestellt ist, bestehend aus einem Kofferboden 206 mit Füßen oder Rollen 208 und Schmetterlingsverschlüssen 210, wobei dieser Kofferboden nur eine solche Umrandung besitzt, daß das auf den am Kofferboden angeschraubten Basisrahmen 12 aufgesetzte Gerät voll zugänglich ist.

Auf diesen Kofferboden 206 läßt sich dan ein haubenförmiger Kofferdeckel 212 oder 214 mit Hilfe weiterer Schmetterlingsverschlüsse (oder auch ähnlicher Verschlüsse) aufsetzen, wobei je nach Gerätehöhe unterschiedliche Haubenhöhe angewendet werden kann.

Es ist auch möglich, zwischen Boden 206 und Haube 212 oder 214 Zwischenelemente 216 einzuschieben, wenn eine größere Turmhöhe aufgebaut wird. Insbesondere könnte für jedes Gerät oder auch für jede Gerätegruppe bestimmter Höhe ein entsprechendes Zwischenelement 216 von entsprechender Erstreckung vorhanden sein, so daß sich in der Kombination oder Auftrennung von Systemen eine exakte Anpassung an die jeweilige vorgesehene Stapelhöhe ergibt.

Es ist zweckmäßig, den Gehäuserahmen eine solche Abmessung zu geben, daß eine Anpassung an beispielsweise 19-zöllige Einbauschränke sich ergibt.

Je nach Gewicht der einzuschiebenden Geräte können auch zusätzliche Stützwinkel angebracht werden, beispielsweise auf der Hinterseite oder bei der Anordnung gemäß Fig. 9 auch auf der Unterseite der schräg verlaufenden Rack-Profile. Möglich ist auch die Anbringung von Gleitschienen, und zwar auf einfachste Weise an den seitlichen Führungsnuten 39 der Rack-Profile, mittels Klemmverschraubung.

Durch die versteifende Wirkung der Verriegelungsrahmen werden jedoch in den meisten Fällen derartige Stützwinkel entbehrlich sein.

Ein großer Vorteil des erfindungsgemäßen Gehäusesystems ist die Tatsache, daß selbst dann, wenn dieses Gehäusesystem an 19-Zoll-Geräte angepaßt ist, durch die besondere Ausführungsform auch an dieses 19-Zoll-Maß nicht angepaßte Geräte in eine 19-Zoll-Formation integriert werden können, wie beispielsweise Tastaturen, Mischer oder Computer, die mit 19-Zoll-Geräten zusammenarbeiten sollen, selbst aber ein anderes Format, insbesondere ein kleineres Format einnehmen, und zwar durch Montage des zweiten (unteren) Basisrahmens 14 unter ein zuoberst einzugliederndes Nicht-19"-Gerät oder durch Anbringen des ersten (oberen) Basisrahmens 12 sowie des zweiten (unteren) Basisrahmens 14 an ein zwischen den Moduln einzugliederndes Nicht-19"-Gerät (oder Gerätekombination). Dieses kann sowohl durch Horizontal-als auch durch Vertikaldurchbrüche erfolgen (ggf. elastisch gelagert). Eine solche Kombination kann dann fest verkabelt und getestet im Case-Gehäusesystem zusammenhängend transportiert werden, was am Anwendungsort Aufbauzeit einspart.

Wenn ein 19-Zoll-Maß (entsprechend 483 mm) gewählt wird, ist es günstig, bestimmte Höhenabstufungen vorzusehen, beispielsweise Höhenabstufungen des Maßes 1 3/4 Zoll entsprechend 44,45 mm, wobei dann die einzelnen Moduln z. B. eine Höhe vom 1 bis 8fachen dieser Höheneinheit besitzen können, siehe Fig. 8, linke Seite, für die Moduln, und rechte Seite für die Kofferringe 216.

Es wurde bereits erwähnt, daß das U-Profil gemäß Fig. 3c, rechte Seite, ein sogenanntes Hybridschließprofil darstellt, das im Handel erhältlich ist. Dieses muß nur auf die richtige Länge abgeschnitten und, aus optischen Gründen und wegen verringerter Verletzungsgefahr, in der in Fig. 3c angegebenen Weise abgeschrägt werden. Gleiches gilt übrigens auch für das L-Profilstück 54 bzw. 158, Fig. 3a links.

Auch die Rackschienenprofilstücke sowie auch die L-Profile sind jeweils im Handel erhältliche Fertigprodukte, so daß aus diesem Grunde mit sehr einfachen Mitteln der Erfindungsgegenstand produzierbar ist.

Als Profilmaterial hat sich Aluminium bewährt, wobei allerdings für die L-Profilschiene, die üblicherweise aus Aluminiumprofil der Abmessungen 40 x 15 x 2 mm hergestellt wird, auch Stahlblech sich anbietet, und zwar deshalb, weil Stahlblech stanzbar ist und dadurch die Herstellung der verschiedenen Durchbrüche erheblich erleichtert wird. Dies gilt auch insbesondere für den Verriegelungshebel (92) und den Schwenkhebel (86), wobei man hie die Abstände der Ausstanzungen des Verriegelungshebels (92) und des Schwenkhebels (86) auf das gleiche Maß anpassen sollte, damit bei der Erstellung der Stanzwerkzeuge nur ein Auswechseln der entsprechenden Stempel und Matrizen erforderlich wäre.

Bei den Kofferelementen wird man üblicherweise Sperrholz mit Aluminiumprofilversteifungen vorsehen, wie sie bei Flugkoffern sich eingebürgert haben. Der Bodendeckel des Koffers, 206, könnte dann eine Schenkellänge von 40 mm aufweisen, während das Zwischenteil oder Kofferring 216 je nach Bedarf Maße von 250, 375, 500, 625 usw. besitzen könnte. Die Haube 212 wiederum hat z. B. eine Schenkellänge von 80 mm, während die größere Haube 214 eine Schenkellänge von 250 oder 375 mm besitzt.

Um beim Aufsetzen von Kofferringen 216 oder Hauben 212, 214 die Moduln, insbesondere aber die eingesetzten Geräte 24 und deren vorspringende Teile, wie Bedienungsknöpfe und Anschlußkabel, zu schützen, kann an den Kofferring- oder Kofferhaubenecken jeweils ein Bügel 216 vorgesehen sein, der eine solche Breite besitzt und so vorspringend angebracht ist, daß er mit der seitlichen Außenfläche 218, 220 (Fig. 7) der zugehörigen Rackprofilstücke 16 in Eingriff kommt und so eine Führung beim Überstülpen der Kofferelemente ergibt.

Die Fig. 10 läßt im übrigen erkennen, daß das W-Profil auch bei den Kofferelementen zur Stabilisierung der Auflagekanten aufeinandergesetzter Elemente verwendet wird, siehe Bezugszahl 222.

## Patentansprüche

1. Case-Gehäusesystem, bestehend aus einem aus Rack-Profilen aufgebauten Gehäuserahmensystem, in das elektronische Geräte einbringbar sind und das mit Abdeckwänden oder Abdeckhauben versehbar ist, dadurch gekennzeichnet, daß das Gehäuserahmensystem einen oder mehrere Rahmenmoduln (10) umfaßt, jeweils bestehend aus einem oberen Basisrahmen (12) sowie aus einem über Rack-Profilstücke (16, 17, 18, 19) mit dem oberen Basisrahmen (12) verbundenen unteren Basisrahmen (14), wobei der obere Basisrahmen mit einer verriegelbaren Aufnahme für einen unteren Basisrahmen (14) eines anderen Moduls (10) versehen ist, und wobei der untere Basisrahmen zum verriegelbaren Einbringen in den oberen Basisrahmen (12) eines weiteren Moduls (10), eines Case-Gehäuse-Kofferbodens (206) oder einer Case-Gehäuse-Bodenauflage geeignet ist.

2. Gehäusesystem nach Anspruch 1, dadurch gekennzeichnet, daß untere und obere Basisrahmen (14, 12) rechteckig sind und aus L-Profilen (154, 156, 158, 160 bzw. 54, 56, 58, 60) bestehen, wobei auf zwei parallele (vorzugsweise den längeren) Rahmenseiten (54, 58 bzw. 154, 158) U-Profile (66, 68 bzw. 166, 168) mit W-förmig ausgebildetem U-Steg-Profil (70) aufgesetzt sind.

3. Gehäusesystem nach Anspruch 2, dadurch gekennzeichnet, daß die W-Profilierung (70) derart angeordnet ist, daß beim verriegelnden Zusammenbau eines oberen Basisrahmens (12) mit einem unteren Basisrahmen (14) die W-Profile (70) der beiden Rahmen (12, 14) kammartig ineinandergreifen.

4. Gehäusesystem nach Anspruch 2 oder 3, dadurch gekennzeichnet, daß das L-Profil unterschiedlich lange Schenkellänge (T, E) aufweist und die Basisrahmen (12, 14) durch Aufeinanderlegen und Fixieren der längeren Schenkel (E) an den Rahmenecken derart aufgebaut sind, daß die kürzeren Schenkel (D) von aneinanderstoßenden L-Profilen (z. B. 58, 60) in entgegengesetzte Richtungen weisen.

5. Gehäusesystem nach Anspruch 4, dadurch gekennzeichnet, daß die Ausrichtung der kürzeren Schenkel (D) bei erstem und zweiten Basisrahmen (14, 12) komlementär ist, vorzugsweise derart, daß die L-Profile der längeren oder kürzeren Rahmenseite (z. B. 54, 58 bzw. 154, 158) von miteinander verriegelten Basisrahmen ein geschlossenes Rechteckprofil bilden, in dem die verkämmten W-Profile (70) gerade passend aufnehmbar sind.

6. Gehäusesystem nach Anspruch 5, dadurch gekennzeichnet, daß L-Profile der kürzeren oder alternativ längeren Rahmenseiten (z.B. 56, 60 bzw. 156, 160) von miteinander verriegelten Basisrahmen (12, 14) ein gespaltenes T bilden, wobei die beiden Hälften des gespaltenen T-Beins zum Rahmeninneren gerichtet sind und zwischen sich einen Schwenkhebel (86) aufnehmen, der mit seinem aus dem T nach außen (oben) herausragenden Teil eine Handhabe (90) für die Verriegelung bildet und mit seinem aus dem T nach innen (bzw. unten) herausragenden Teil an einem Verriegelungshebel (92) angelenkt ist, um diesen Verriegelungshebel (92) gegen Federkraft (108) aus seiner Verriegelungsstellung herausschwenken zu können.

7. Gehäusesystem nach Anspruch 6, dadurch gekennzeichnet, daß der Verriegelungshebel (92) an seinem einen Ende nahe einer Rahmenecke angelenkt ist (98) und von einer Feder (108) in eine Endstellung gedrängt wird, in der er mit seinem anderen Ende (116) sich an das aus L-Profilen gebildete Rechteckprofil derart anlegt, daß die W-Profile (70) innerhalb des Rechteckprofils in Kämmstellung gehalten werden.

8. Gehäusesystem nach einem der Ansprüche 1 bis 7, dadurch gekennzeichnet, daß die das Dach des T bildenden L-Profilschenkel Bohrungen (21) zur Befestigung von Rack-Profilstücken (16, 17, 18, 19) aufweisen.

9. Gehäusesystem nach einem der Ansprüche 1 bis 8, dadurch gekennzeichnet, daß die Rack-Profilstücke (16, 17, 18 19) von aufeinandergesetzten und verriegelten Rahmenmoduln (10) einen zur Gehäusefrontfläche bzw. Gehäuserückenfläche weisenden Aufnahmeprofilschlitz (38) zur Befestigung der Frontplatte (22) von in die Rahmenmoduln (10) eingeschobenen Geräten (24), Vor- und Rückwandteile, Versteifungsschienen, o. dgl., aufweist.

10. Gehäusesystem nach Anspruch 9, dadurch gekennzeichnet, daß der obere Basisrahmen (12) senkrecht zur Rahmenfläche verlaufende Bohrungen (146) zur Befestigung an einem Kofferboden (206), Bodenaufsatz o. dgl. besitzt.

11. Gehäusesystem nach einem der Ansprüche 1 bis 10, dadurch gekennzeichnet, daß beim obersten Rahmenmodul (10) anstelle des aus L-Profilen bestehenden oberen Rahmens (12) ein aus Rackschienen aufgebauter Rahmen (148, 150) vorgesehen ist.

12. Gehäusesystem nach Anspruch 11, dadurch gekennzeichnet, daß je zwei der Rack-Profilstücke an den Ecken des Rackschienenrahmens von einer linken und einer rechten, horizontal oder nach vorn abfallend angeordneten Seiten-Rack-Profilschiene starr verbunden sind, deren Profil identisch mit dem der Rack-Profilstücke und als deren geknickte Fortsetzung angeordnet ist.

13. Gehäusesystem nach einem der Ansprüche 1 bis 12, dadurch gekennzeichnet, daß je zwei Rack-Profilstücke an den Ecken eines Rahmens durch ein angeschraubtes Winkelstück versteift sind.

14. Gehäusesystem nach Anspruch 13, dadurch gekennzeichnet, daß die Winkelstücke gleichzeitig Gleitschienen zum zusätzlichen Abstützen und leichteren Ein- und Ausschieben von schweren Geräten bilden.

15. Gehäusesystem nach einem der Ansprüche 1 bis 14, dadurch gekennzeichnet, daß jedes Rahmenmodul von einem Kofferelement (216) gleicher Vertikalerstreckung umhüllt ist.

16. Gehäusesystem nach Anspruch 15, dadurch gekennzeichnet, daß die Kofferelemente (216) untereinander und mit dem Gehäusekofferboden (206) und mit einem Gehäusekofferdeckel (212, 214) mittels Schnappverschlüssen, Schmetterlingsverschlüssen (210), Aushängescharnieren o. dgl. verbunden sind und zusammen einen geschlossenen, ggf. Traggriffe und Laufrollen (208) aufweisenden Behälter (204) bilden.

**Claims**

1. Case-housing system, consisting of a housing frame system constructed from cavity profile section in which electronic devices can be housed and which can be provided with cover walls or caps, characterised in that the housing frame system includes one or several frame modules (10) each consisting of an upper base frame (12) and a lower base frame (14) connected with the upper base frame by means of cavity profile sections (16, 17, 18, 19), whereby the upper base frame is provided with a lockable location for a lower base frame (14) of another module (10), and whereby the lower base frame is suited to the lockable insertion in the upper base frame (12) of a further module (10), of a case-housing box base (206) or of a case-housing base support.

2. Housing system according to claim 1, characterised in that the lower and the upper base frame (14, 12) ar rectangular and consist of L-profiles (154, 156, 158, 160 or 54, 56, 58, 60), whereby U-profiles (66, 68 or 166, 168) with a W-shaped U-web profile are mounted on two parallel frame sides (54, 58 or 154, 158) (preferably the longer ones).

3. Housing system according to claim 2, characterised in that the W-profiling is arranged in such a way that in the case of the locking assembly of an upper base frame (12) with a lower base frame (14) the W-profiles (70) of the two frames (12, 14) engage with one another in cog-like manner.

4. Housing system according to claim 2 or 3, characterised in that the L-profile has arms (T, E.) of different lengths and the base frames (12, 14) are constructed through superposing and fixing the longer arms (E) onto the frame edges in such a way that the shorter arms (D) of profiles (e.g. 58, 60) abutting one another point in different directions.

5. Housing system according to claim 4, characterised in that the alignment of the shorter sides (D) in the case of the first and second base frames (14, 12) is complementary, preferably in such a way that the L profiles of the longer or shorter frame sides (e.g. 54, 58 or 154) of base frames locked with one another form a closed rectangular profile in which the cogged W profiles (70) can be received, fitting exactly.

6. Housing system according to Claim 5, characterised in that the L profiles of the shorter or alternatively longer frame sides (for example 56, 60 or 156, 160) of base frames (12, 14) locked with one another form a split T, whereby the two halves of the split T-leg point towards the inside of the frame and receive a swivelling lever (86) between them which with its part projecting outwards (upwards) from the T forms a handle (90) for the locking device and with its part projecting inwards (downwards) from the T is linked to a locking lever (92) in order to be able to sway this locking lever (92) against spring tension.

7. Housing system according to claim 6, characterised in that the locking lever (92) is linked at one of its ends near to a frame edge (92) and is driven by a spring (108) into an end position in which it rests with its other end (116) against the rectangular profile formed from L profiles (70) in such a way that the W profiles (70) are held inside the rectangular profile in the cog position.

8. Housing system according to one of claims 1 to 7, characterised in that the L-profile arms forming the top of the T have bores (21) for the attachment of cavity profile sections (16, 17, 18, 19).

9. Housing system according to one of claims 1 to 8, characterised in that the cavity profile sections (16, 17, 18, 19) of frame modules (10) placed on top of one another and locked have a receiving slot (38) pointing towards the housing front surface or housing back surface for the attachment of the front plate (22) of devices (24) pushed into the frame modules (10), front and rear wall parts, reinforcing bars or the like.

10. Housing system according to claim 9, characterised in that the upper base frame (12) has bores (146) running vertically to the frame surface for attachment to a box base (206), base support or the like.

11. Housing system according to one of claims 1 to 10, characterised in that in the case of the uppermost frame module (10) instead of the upper frame (12) consisting of L-profiles a frame (148, 150) constructed from cavity strips is provided.

12. Housing system according to one of claims 1 to 10, characterised in that two of the cavity profile sections at the edges of the cavity strip frame are rigidly connected by a left and a right side-cavity profile strip, said strips being arranged identically to that of the cavity profile sections and as the flexed continuation of the latter.

13. Housing system according to one of claims 1 to 12, characterised in that the two cavity profile sections are reinforced at the edges of a frame through a screwed-on elbow.

14. Housing system according to claim 13, characterised in that the elbows form at the same time slide rails for the aditional support and easier insertion and removal of heavy devices.

15. Housing system according to one of claims 1 to 14, characterised in that each frame module is covered with a box element (216) of the same vertical extent.

16. Housing system according to claim 15, characterised in that the box elements (216) are connected one beneath the other and with the housing box base (206) and with a housin box lid (212, 214) by means of spring catches, butterfly locks (210), demountable hinges or the like and together form a closed container (204) having carrying handles and rollers (208) if need be.

## Revendications

1. Système de casiers du type case in case qui est constitué par un système de cadres de casiers réalisés au moyen de profils à râtelier, dans lequel peuvent être placés des appareils électroniques et qui peut être muni de parois couvrantes ou de hottes couvrantes, caractérisé en ce que le système de cadres de casiers comprend un ou plusieurs modules de cadre (10) constitués chacun par un cadre de base supérieur (12) ainsi que par un cadre de base inférieur (14) relié par des éléments (16, 17, 18, 19) de profils à râtelier au cadre de base supérieur (12), le cadre de base supérieur étant muni d'un dispositif de réception, avec possibilité de verrouillage, d'un cadre de base inférieur (14) d'un autre module (10) et le cadre de base inférieur étant conçu pour être introduit de manière à pouvoir être verrouillé dans le cadre de base supérieur (12) d'un autre module (10), du fond (206) du coffre du casier du type case in case ou d'une partie d'appui du fond du casier du type case in case.

2. Système de casiers selon la revendication 1, caractérisé en ce que les cadres de base inférieur et supérieur (14, 12) sont rectangulaires et constitués par des profils en L (154, 156, 158, 160 ou 54, 56, 58, 60), des profils en U (66, 68 ou 166, 168) ayant un âme(70) en forme de W étant placés sur deux côtés parallèles du cadre, de préférence les plus onsg (54, 58 ou 154, 158).

3. Système de casiers selon la revendication 2, caractérisé en ce que les profils en W (70) sont réalisés de telle manière qu'après assemblage avec verrouillage d'un cadre de base supérieur (12) et d'un cadre de base inférieur (14) les profils en W (70) des deux cadres (12, 14) sont encastés l'un dans l'autre.

4. Système de casiers selon une des revendications 2 ou 3, caractérisé en ce que le profil en L comporte des ailes de longueurs différentes (T, E) et que les cadres de base (12, 14) sont réalisés par superposition et fixation des ailes les plus longues (E) aux coins du cadre, de telle manière que les ailes les plus courtes (D) de profils en L contigus (par exemple 58, 60) sont tournés en sens inverse.

5. Système de casiers selon la revendication 4, caractérisé en ce que les ailes les plus courtes (D) dans les premier et deuxième cadres de base (14, 12) sont disposées d'une manière complémentaire, de préférence de telle manière que les profils en L du côté le plus long ou le plus court du cadre (par exemple 54, 58 ou 154, 158) de cadres verrouillés ensemble forment un profil rectangulaire fermé dans lequel les profils en W encastrés (70) peuvent s'insérer exactement.

6. Système de casiers selon la revendication 5, caractérisé en ce que les profils en L des côtes les plus courts ou les plus longs du cadre (par example 56, 60 ou 156, 160) de cadres de base (12, 14) verrouillés ensemble forment un T fendu, les deux moitiés de la pièce en T étant dirigées vers l'intérieur du cadre et comprenant entre elles un levier pivotant (86) dont la partie qui dépasse du T vers l'extérieur (vers le haut) forme une poignée de verrouillage et dont la partie qui dépasse du T vers l'intérieur (ou vers le bas) s'articule sur un levier de verrouillage (92) de manière à pouvoir, en s'opposant à une force élastique (108), dégager par pivotement ce levier de verrouillage (92) de sa position de verrouillage.

7. Système de casiers selon la revendication 6, caractérisé en ce que le levier de verrouillage (92) s'articule (98), à l'une de ses extrémités, à proximité d'un coin du cadre et est poussé par un ressort (108) dans une position d'extrémité dans laquelle il s'applique, par son autre extrémité (116), contre le profil rectangulaire formé par les profil en L, de telle manière que les profils en W (70) sont maintenus à l'intérieur du profil rectangulaire en position d'encastrement.

8. Système de casiers selon une des revendications 1 à 7, caractérisé en ce que les ailes des profils en L qui constituent le toit du T comportent des alésages (21) pour la fixation d'éléments de profil à râtelier (16, 17, 18, 19).

9. Système de casiers selon une des revendications 1 à 8, caractérisé en ce que les éléments de profil en râtelier (16, 17, 18, 19) de modules (10) de cadre superposés et verrouillés comportent une fente de réception (38) tournée vers la surface frontale du casier ou la surface arrière du casier pour la fixation de la plaque frontale (22) d'appareils (24) insérés dans les modules de cadre (10), de parties de parois avant et arrière, de rails de raidissement ou d'éléments analogues.

10. Système de casiers selon la revendication 9, caractérisé en ce que le cadre de base supérieur (12) comporte des alésages (146) orientés perpendiculairement à la surface du cadre pour la fixation à un fond de coffre (206), à une pièce montée sur le fond ou à un élément analogue.

11. Système de casiers selon une revendication 1 à 10, caractérisé en ce qu'en ce qui concerne le module de cadre supérieur (10) il comporte, au lieu du cadre supérieur (12) constitué par des profils en L, un cadre (148, 150) constitué par des rails à râtelier.

12. Système de casiers selon la revendication 11, caractérisé en ce que deux des éléments de profil à râtelier sont reliés rigidement, aux coins du cadre en rails à râtelier, par un rail profilé à râtelier latéral disposé horizontalement à gauche et à droite ou en pente vers l'avant, qui a un profil identique à celui des éléments de profil à râtelier et qui constitue comme leur prolongement suivant une autre direction.

13. Système de casiers selon une des revendications 1 à 12, caractérisé en ce que les éléments de profil à râtelier sont raidis deux par deux, au niveau des coins d'un cadre, par une cornière fixée par vissage.

14. Système de casiers selon la revendication 13, caractérisé en ce que les éléments de cornière constituent en même temps des glissières assurant un appui supplémentaire et facilitant l'introduction et l'extraction d'appareils lourds.

15 Système de casiers selon une des revendication 1 à 14, caractérisé en ce que chaque module de cadre est entouré par un élément de coffre (216) de même dimension verticale.

16. Système de casiers selon la revendication 15, caractérisé en ce que les éléments de coffre (216) sont reliés les uns aux autres, au fond (206) du coffre du casier et à un couvercle (212, 214) de coffre de casier au moyen de fermetures à déclic, de fermetures à papillon (210) de charnières suspendues ou de dispositifs analogues et forment, par leur assemblage, un récipient fermé (204) pouvant comporter des poignées de transport ou des roulettes (208).

Fig. 1a

EP 0 186 857 B1

Fig.1b

Fig. 2a

Fig. 2b

EP 0 186 857 B1

Fig. 2c

Fig. 2d

Fig. 2e

Fig. 2g

E – w

Fig. 2f

EP 0 186 857 B1

54;158

58;154

101

101

E−w

E−w

62

D

E

D

E

Fig.3a

156    160

D    E    D    E

Fig.3b

56;60   66;68

64

D   E

70

Fig. 3c

Fig. 3d

136

134,140

32

106

132

134

108

Fig.3e

## 16

50

48

(b)

## 16

B

X

B

C

(c)

## 16

44

40

42    46

(a)

Fig.4

Fig. 5

EP 0 186 857 B1

Fig. 6

22 —

220

24

218

28

A

Fig. 7

316

222

Fig. 10

Fig. 8

$h_{Modul} = n \cdot u + D; \; 1 \leq n \leq 8$

$u \, \hat{=} \, HE \, (\text{Höheneinheit}) = 1^{3}/_{4} \, Zoll \approx 45 \, mm$

$D = 15 \, mm$

$\sum h_{Modul} \leq \sum h_{Koffer}$

205    202

148

150

200

Fig. 9

EP 0 186 857 B1